# EUROPEAN PATENT APPLICATION

(11) **EP 1 143 491 A1**
(43) Date of publication of application: **10.10.2001**
(21) Application number: 99931533.6
(22) Date of filing: 26.07.1999
(51) Int. Cl.: H01L 21/027, G03F 7/20

(54) **OPTICAL DEVICE, EXPOSURE SYSTEM, AND LASER BEAM SOURCE, AND GAS FEED METHOD, EXPOSURE METHOD, AND DEVICE MANUFACTURING METHOD**

(30) Priority: 19.11.1998 JP 33003398
(71) Applicant: Nikon Corporation, Tokyo 100-8831 (JP)
(72) Inventor: MOTEGI, K., Nikon Corp. Int. Prop. Headquarters, Chiyoda-ku, Tokyo 100-8331 (JP); OSHIKAWA, S., Nikon Corp., Intel.Prop. Headqu, Chiyoda-ku, Tokyo 100-8331 (JP)
(74) Representative: Banzer, Hans-Jörg, Dipl.-Ing.
(86) International application number: JP9903985
(87) International publication number: WO0031780

(57) **Abstract**

An optical apparatus, an exposure apparatus, and a laser light source maintain a satisfactory working environment during maintenance, an abnormal state, or the like, and suppress clouding of optical elements. An inert gas supply system (33) and a dry air supply system (35) are selectively connected to a first lens barrel (46) and a second lens barrel (48) of an exposure apparatus main body (11) and a light source chamber (16) of a laser apparatus (12). Oxygen sensors (78, 42) for measuring oxygen concentration and exhaust volume monitors (77, 41) for detecting the exhaust volume of an exhaust duct (40) are arranged in a chamber (45) of the exposure apparatus main body (11) and a chamber (15) of the laser apparatus (12). When at least one of the oxygen concentrations detected by the oxygen sensors (78, 42) and the exhaust volume detected by the exhaust volume monitors (77, 41) falls below a predetermined value, the purge gas supplied to the first and second lens barrels (45, 46) and the light source chamber (16) is switched from inert gas to dry air.

## Description

### Technical Field

The present invention relates to an optical apparatus accommodating various kinds of optical elements. More particularly, the present invention relates to an exposure apparatus used in the photolithography process for manufacturing, for example, micro devices, such as, semiconductor devices, liquid crystal display devices, image pick-up devices, or thin film magnetic heads, and to a laser light source used in the exposure apparatus, a gas supply method, an exposure method, and a device manufacturing method.

### Background Art

An exposure apparatus is equipped with a light source emitting exposure light having a predetermined wavelength, an illumination system illuminating a mask with the exposure light, and a projection optical system for projecting a circuit formed on the mask onto a substrate based on the illumination of the illumination system. In each lens barrel of the light source, the illumination system, and the optical projection system, a plurality of optical elements such as lenses, mirrors, or filters, are accommodated.

The exposure apparatus is arranged in an air-conditioned environment that is maintained at a predetermined temperature and humidity. This maintains constant environmental conditions during exposure. A small amount of contaminants, such as organic silicides and ammonium bases, is present in the atmosphere of a clean room of a micro device plant in which the exposure apparatus is operated. If such contaminants enter the exposure apparatus and the lens barrels, the contaminants adhere to the surfaces of the optical elements and cloud the optical elements. An exposure apparatus provided with a mechanism to purge the interior of the barrels with gas, such as air, from which the contaminants have been removed has been proposed to prevent clouding.

The recent trend to develop finer semiconductor integrated circuits has resulted in a stronger demand for an exposure apparatus having a finer resolution. In response to such demand, light sources having a shorter wavelength, for example, an i-line (λ =365nm), a KrF excimer laser (λ =248nm), still further, an ArF excimer laser (λ =193nm), and an F₂ excimer laser (λ =157nm), are now being used for exposure light in place of, for example, the g-line (λ =436nm), which was widely used in the prior art. In an exposure apparatus using the KrF excimer laser as exposure light, moisture within the lens barrels may cloud the optical elements. Thus, the lens barrels are purged with a gas, such as air, the moisture content of which is lower than a predetermined level.

In exposure light having a wavelength equal to or less than that of the ArF excimer laser light, the overlapped portion between the emission spectrum of the exposure light and the absorption spectrum of oxygen in the atmosphere increases. In such case, as the exposure light passes through the oxygen, the oxygen absorbs the energy of the exposure light. This significantly attenuates the energy amount and produces ozone through photochemical reaction. Therefore, when ultra-short-wavelength exposure light is applied, the lens barrel interior is purged with, for example, nitrogen gas to supply the substrate with a stable exposure energy amount and prevent the optical elements from clouding. Further, the lens barrels are connected to an exhaust duct in a micro device plant, and the nitrogen gas used as ambient gas in the barrels is discharged from the plant.

A shutter, which is provided on the exposure apparatus housings (e.g., a main chamber accommodating the exposure apparatus main body, a laser chamber accommodating a laser source), needs to be opened when exchanging masks or wafers and when replacing optical elements for maintenance. In this situation, when the lens barrels are purged with nitrogen gas, a decrease in the hermeticity of the barrels may cause the nitrogen gas to leak from the lens barrels into the housings and be discharged into the clean room.

Further, when the exhaust duct has a deficiency and its exhaust capability is low, the nitrogen gas exhausted from the plant flows backward to the housings of the exposure apparatus and may further leak into the clean room. Such situations may deteriorate the working environment in the clean room.

When power supply to the exposure apparatus and to the exhaust duct is shut off because of a power outage or a shutdown, the purge gas supply mechanism is also stopped. In this case, the contaminants in the atmosphere of the clean room cannot be prevented from entering the lens barrels and may cloud the optical elements.

A first object of the present invention is to provide an optical apparatus, an exposure apparatus, and a laser light source that maintains a satisfactory working environment during, for example, maintenance or transportation of the exposure apparatus and during abnormal conditions of the exposure apparatus and the exhaust apparatus.

A second object of the present invention is to provide an optical apparatus, an exposure apparatus, and a laser light source that suppress clouding of the optical elements resulting from a shutdown of the exposure apparatus and the exhaust apparatus.

### Disclosure of the Invention

A first mode of the present invention provides an optical apparatus including an airtight chamber for accommodating optical elements. The optical apparatus includes a first purge mechanism for supplying a first gas into the airtight chamber, a second purge mechanism for supplying a second gas having a composition differing from the first gas into the airtight chamber, an operation condition detecting mechanism for detecting an operation condition of the optical apparatus, and a control apparatus for selectively connecting the airtight chamber to the first purge mechanism or the second purge mechanism based on a detection result of the operation condition detecting mechanism. Thus, the purge gas appropriate for the operation conditions is selectively supplied into the airtight chamber based on the detection results of the operation condition detecting mechanism.

The optical apparatus further includes a light source for emitting illumination light. Further, the light source may be an excimer laser light source for emitting excimer laser light. In this case, the excimer light, which provides high energy light and tends to cloud the optical elements and requires purge gas to be used under stricter conditions, is effective.

Also, the optical apparatus may further include an illumination optical system having a plurality of optical elements and illuminating a mask with illumination light, and at least some of the plurality of optical elements of the illumination optical system may be accommodated in the airtight chamber. In this case, temporal changes in the intensity on the mask of illumination light emitted from the illumination optical system are suppressed, and a more accurate mask pattern transference results.

Further, the optical apparatus may further include a projection optical system that projects at least part of the pattern formed on the mask onto a substrate. In this case, temporal changes in the pattern image intensity are suppressed, and a more accurate mask pattern transference results.

Further, it is preferred that the first gas be inert gas and that the second gas be oxygen, the concentration which is at least the same as that in the atmosphere, or mixed gas containing oxygen. In this case, by supplying the inert gas into the airtight chamber during normal mode exposure operation, contaminants and oxygen are removed from the airtight chamber, and clouding of the optical elements is suppressed. On the other hand, by supplying the purge gas containing oxygen into the airtight chamber during maintenance or abnormal conditions, or the like of the optical apparatus, a satisfactory working environment is maintained even when the hermeticity of the airtight chamber is decreased.

Further, the optical apparatus may include a cleaning apparatus arranged in a flow path of the first gas and the second gas to remove impurities from the gases. The purge gas supplied into the airtight chamber is always kept clean by the cleaning apparatus, and clouding of the optical elements is suppressed.

Further, the optical apparatus includes a housing for accommodating the airtight chamber, the operation condition detecting mechanism includes an environment monitoring means for detecting the concentration of predetermined gas inside or outside the housing, and the control apparatus switches the purge mechanism connected to the airtight chamber from the first purge mechanism to the second purge mechanism based on the detection results of the environment monitoring means when the concentration of the predetermined gas falls below a predetermined value. In this case, by using, for example, an oxygen sensor as the environment monitoring means to detect the oxygen concentration, the oxygen concentration in the housing or in the clean room in which the optical apparatus is installed may be controlled. Thus, a satisfactory working environment is maintained.

Further, the optical apparatus includes an exhaust apparatus connected to the airtight chamber, the operation condition detecting mechanism includes an exhaust monitoring means for detecting the exhaust efficiency of the exhaust apparatus, and the control apparatus switches the purge mechanism connected to the airtight chamber from the first purge mechanism to the second purge mechanism based on the detection results of the exhaust monitoring means when the exhaust volume falls below a predetermined value. In this case, because the use of the first gas is stopped when an abnormality of the exhaust apparatus is detected, a satisfactory working environment is maintained.

When at least one of the operation condition detecting mechanism and the control apparatus is deactivated, the purge mechanism connected to the airtight chamber is switched from the first purge mechanism to the second purge mechanism. In this case, because the use of the first gas is stopped when the optical apparatus is not operated, a satisfactory working environment is maintained.

Further, the control apparatus may connect the first purge mechanism to the airtight chamber when the optical apparatus operates and the control apparatus may connect the second purge mechanism to the airtight chamber when a condition for using the first gas is not satisfied. In this case, the first gas is supplied into the airtight chamber during normal operation, and the second gas is supplied into the airtight chamber during maintenance or under abnormal conditions or the like of the optical apparatus.

Further, when part of the housing accommodating the airtight chamber is in an opened state, when the power supply of the optical apparatus is off, or when the optical apparatus is being transported, assembled, or adjusted, the second purge mechanism may be connected to the airtight chamber. In this case, because the second gas is supplied into the airtight chamber during maintenance of the optical apparatus, exchange of masks, substrates, or the like, and a non-operating state, transportation, assembly, or adjustment, a satisfactory working environment is maintained.

Further, the optical apparatus may include a holding means that stores and holds the second gas. In this case, the inside of the airtight chamber may be purged with the second gas even when the second gas cannot be supplied to the optical apparatus from a factory utility plant during, for example, the transportation or assembly of the optical apparatus.

A second mode of the present invention provides an exposure apparatus that transfers a mask pattern onto a substrate. The exposure apparatus includes a light source for emitting illumination light, an airtight chamber accommodating at least some of a plurality of optical elements disposed between the light source and the substrate, a first purge mechanism for supplying first gas into the airtight chamber, a second purge mechanism for supplying second gas having a composition differing from the first gas into the airtight chamber, an operation condition detecting mechanism for detecting the operation conditions of the exposure apparatus, and a control apparatus for selectively connecting the airtight chamber to the first purge mechanism or the second purge mechanism based on the detection results of the operation condition detecting mechanism. Because contaminants in the airtight chamber accommodating the optical elements of the exposure apparatus are removed by the first or second gas, the clouding of the optical elements is suppressed. Thus, degradation of the accuracy and efficiency of the mask pattern transference operation onto the substrate is avoided. Further, a satisfactory working environment is maintained when masks and substrates are exchanged and during maintenance, or the like.

Further, the airtight chamber may include a first airtight chamber for accommodating the optical elements in the light source, a second airtight chamber for accommodating at least one optical element disposed between the light source and the mask, and a third airtight chamber for accommodating at least one of the optical elements disposed between the mask and the substrate. In this case, the clouding of respective optical elements disposed in the light source, between the light source and the mask, and between the mask and the substrate is suppressed.

The exposure apparatus may include a recovering apparatus for recovering the first gas through at least one of the housing in which the airtight chamber is accommodated, the first airtight chamber, the second airtight chamber, and the third airtight chamber. In this case, the first gas supplied to the airtight chamber is recovered by the recovering apparatus. By reusing the recovered first gas, the running cost of the exposure apparatus is reduced.

The second gas may be chemically clean dry air. In this case, when the illumination light does not pass through the airtight chamber, the airtight chamber is purged with the chemically clean dry air. Thus, the adhesion or deposition of contaminants on the surface of each optical element in the airtight chamber is precluded.

Further, the exposure apparatus may further include a sensor for detecting the concentration of either one of the first gas or oxygen in the airtight chamber, and a light emission control apparatus for controlling the light source based on the output of the sensor. In this case, in accordance with the concentration of the first gas or oxygen in the airtight chamber, for example, the status of the light source, the emission of the illumination light, or the like may be controlled.

Further, the sensor may detect the oxygen concentration, and the light emission control apparatus may prohibit the emission of the illumination light from the light source until the oxygen concentration becomes less than or equal to a predetermined value. In this case, the emission of the illumination light from the light source is prohibited until, for example, the inside of the airtight chamber is sufficiently purged with the first gas.

The airtight chamber may include a plurality of airtight chambers disposed in a light path of the illumination light, a plurality of sensors may be provided in each of the plurality of airtight chambers, and the light emission control apparatus may control the light source based on outputs of the plurality of sensors. In this case, in accordance with the concentration of, for example, oxygen in each airtight chamber, the status of the light source such as the emission of the illumination light can be controlled.

The exposure apparatus may further include an illumination optical system for illuminating the mask with the illumination light, a projection optical system for projecting at least part of the mask pattern, which is illuminated with the illumination light, onto the substrate, and a transmission system disposed between the light source and the illumination optical system. Further, the plurality of airtight chambers may include at least one of a first airtight chamber provided in the light source, a second airtight chamber accommodating at least some of optical elements forming the illumination optical system, a third airtight chamber accommodating at least some of optical elements forming the projection optical system, and a fourth airtight chamber accommodating at least some of optical elements forming the transmission system. In this case, the optical elements in the light source, at least some of the optical elements of the illumination optical system, some of the optical elements of the projection optical system, and some of the optical elements of the transmission system may be unitized.

Further, the exposure apparatus may include an illumination optical system illuminating the mask with the illumination light, the airtight chamber may include at least two airtight chambers accommodating optical elements of the illumination optical system, and that the at least two airtight chambers may each be provided with a sensor. In this case, for example, an illumination optical system including a movable portion such as a reticle blind or the like may be divided into at least two airtight chambers, one on each side of the movable portion.

Further, the control apparatus may connect the airtight chamber to the second purge mechanism in order to supply the second gas into the airtight chamber when the emission of the illumination light from the light source is interrupted or stopped. In this case, when the emission of the illumination light from the light source is interrupted or stopped due to, for example, power outage, a long shutdown, maintenance, or the like, leakage of the first gas from the airtight chamber is prevented. Further, since the airtight chamber is purged with the second gas, contaminants do not deposit on the optical elements.

Further, the exposure apparatus may include a housing accommodating the airtight chamber and an exhaust apparatus connected to the housing and operated when the second gas is supplied. In this case, when the purge gas in the airtight chamber is switched to the second gas for maintenance or the like, , the exhaust apparatus is opened, and the first gas remaining in the airtight chamber and the housing is discharged externally by the exhaust apparatus.

Further, the exposure apparatus may further include an environment sensor for detecting the environment in the housing, and the exhaust apparatus may be controlled based on the output of the environment sensor. In this case, in accordance with the status of the environment in the housing such as the concentration of oxygen, the status of the light source such as the emission of the illumination light may be controlled.

Further, the housing may include either a first chamber for accommodating the light source or a second chamber for accommodating the exposure apparatus main body. In this case, the airtight chamber of the light source is enclosed in the first chamber, and the airtight chamber of the exposure apparatus is enclosed in the second chamber. Thus, the purge gas in each airtight chamber is not directly discharged from the chamber into an installation environment such as a clean room.

A third mode of the present invention provides a laser light source used in an exposure apparatus that transfers a mask pattern onto a substrate. The laser light source includes a tank for storing a second gas, which has a composition differing from a first gas that is supplied during the operation of the exposure apparatus, and piping for introducing the second gas into the laser light source when the laser light source is separated from the exposure apparatus. In this case, the laser light source is filled with the second gas when the laser light source is transported or separated from the exposure apparatus. Thus, the deposition of contaminants on the surfaces of optical elements disposed in the laser light source is avoided.

A fourth mode of the present invention provides a gas supply method for supplying a predetermined gas to an airtight chamber, which accommodates optical elements and is disposed in an optical apparatus. The method detects the operation condition of the optical apparatus, and selectively supplies the airtight chamber with a first gas or a second gas, the composition of which differs from the first gas, as the predetermined gas based on the detection result.

The first gas may be inert gas, and the second gas may be oxygen, which has at least the same concentration as that in the atmosphere, or mixed gas, which contains oxygen.

The optical apparatus may include a housing accommodating the airtight chamber, the gas concentration in the inside or outside of the housing may be detected, and, based on the results of the detection, the first gas is supplied to the airtight chamber when the gas concentration exceeds a predetermined value, and the second gas is supplied to the airtight chamber when the gas concentration falls below the predetermined value.

The optical apparatus may include an exhaust apparatus connected to the airtight chamber, the exhaust volume of the exhaust apparatus may be detected, the first gas may be supplied to the airtight chamber when the exhaust volume is greater than or equal to a predetermined value, and the second gas may be supplied to the airtight chamber when the exhaust volume falls below the predetermined value.

The first gas may be supplied to the airtight chamber when the optical apparatus is operated.

The second gas may be supplied to the airtight chamber when the airtight chamber or a part of a housing accommodating the airtight chamber is opened or when the power supply of the optical apparatus is off.

The optical apparatus may include an illumination optical system for illuminating the mask with illumination light from a light source, a projection optical system projecting at least part of a pattern of the mask illuminated with the illumination light onto a photosensitive substrate, and a transmission system disposed between the light source and the illumination optical system, and the airtight chamber may be provided in at least one of the illumination system, the projection optical system, and the transmission system.

A fifth mode of the present invention provides an exposure method for projecting a pattern of a mask onto a substrate using the gas supply method of the above fourth mode.

A sixth mode of the present invention provides an exposure method for projecting a pattern formed on a mask onto a substrate. The method supplies the first gas to the airtight chamber using the gas supply method of the above fourth mode before projecting the pattern onto the substrate.

A seventh mode of the present invention provides a device manufacturing method including a step for projecting a pattern formed on a mask onto a substrate. The method supplies the first gas to the airtight chamber using the gas supply method of the above fourth mode before projecting the pattern onto the substrate.

### Brief Description of the Drawings

FIG. 1 is a schematic diagram illustrating the structure of an exposure apparatus and a laser apparatus according to a first embodiment of the present invention.
FIG. 2 is a schematic diagram illustrating the structure of an exposure apparatus and a laser apparatus according to a second embodiment of the present invention.
FIG. 3 is a schematic diagram illustrating the structure of an exposure apparatus and a laser apparatus according to a third embodiment of the present invention.
FIG. 4 is a schematic diagram illustrating the structure of an exposure apparatus and a laser apparatus according to a fourth embodiment of the present invention and to its modification.

### Best Modes for Carrying Out the Invention

### (First Embodiment)

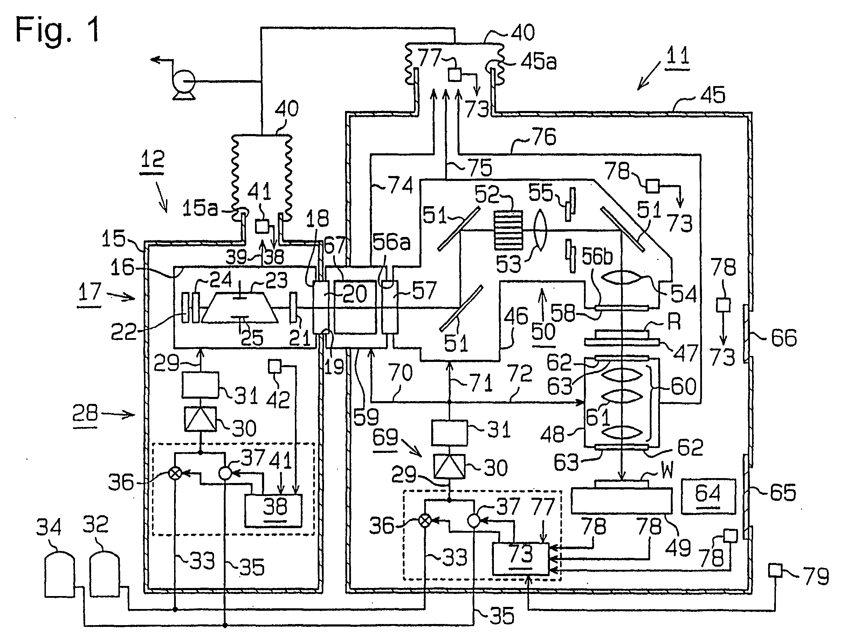

Referring to FIG. 1, the structures of an exposure apparatus main body 11, which serves as an optical apparatus according to a first embodiment of the present invention that is used in the manufacturing process of a micro device such as a semiconductor device, and a laser apparatus 12, which serves as an optical apparatus used as a laser light source of the exposure apparatus main body 11, will be described next.

FIG. 1 is a schematic diagram illustrating the structures of the exposure apparatus main body 11 and the laser apparatus 12. First, the laser apparatus 12 will be described. The laser apparatus 12 has a chamber 15, which serves as a housing, and a light source chamber 16 defined in the chamber 15 and serving as a first airtight chamber. A laser excitation portion 17, which serves as a light source that emits an ArF excimer laser light as illumination light (hereinafter simply referred to as "laser light"), is accommodated in the light source chamber 16. An aperture 18 is formed at one end of the light source chamber 16. Also, at one side surface of the chamber 15, an aperture 19 having a shape corresponding to the aperture 18 is formed. A disc-shaped partition plate 20, which serves as an optical element, is fit into the apertures 18, 19. The partition plate 20 is made from a transparent material (e.g., quartz, fluorite) that allows the transmission of the laser light emitted from the laser excitation portion 17. In the first embodiment, the chamber 15 is connected to an air-conditioning apparatus (not shown) or an air-conditioning apparatus is arranged in the chamber 15 and the inside of the chamber 15 is kept at predetermined temperature and humidity. However, the air-conditioning apparatus need not necessarily be connected to (or be located in) the chamber 15.

The laser excitation portion 17 has a laser gas tube 23, which serves as an optical element, and a front mirror 21 and a rear mirror 22, which serve as a pair of optical elements positioned at each side of the laser gas tube 23. A wavelength narrowing element 24, which serves as an optical element including a prism, a grating, or the like, is arranged between the rear mirror 22 and the laser gas tube 23. Light generated by electric discharge between a pair of electrodes 25 in the laser gas tube 23 reciprocates between the pair of mirrors 21, 22 until the light is amplified to the state of laser oscillation. During this process, the wavelength of the light is narrowed to a predetermined wavelength band as the light passes through the wavelength narrowing element 24.

The light source chamber 16 is connected to a purge gas supply system 28 that supplies purge gas into the chamber. A filter 30, which serves as a cleaning apparatus, and a temperature-controlled dryer 31 are arranged in the path of an air supply pipe 29 connecting the light source chamber 16 and the purge gas supply system 28. The filter 30 removes impurities such as organic silicides, ammonium bases, or the like from the purge gas supplied by the purge gas supply system 28. The temperature-controlled dryer 31 maintains the temperature of the purge gas at a predetermined temperature and controls the moisture in the purge gas at a level of, for example, 5% or lower.

The purge gas supply system 28 includes an inert gas supply system 33, which serves as a first purge mechanism that supplies an inert gas as a first gas from a first tank 32 located in a utility plant of the micro device plant and a dry air supply system 35, which serves as a second purge mechanism that supplies dry air as a second gas, from a second tank 34 located in the same plant. The inert gas may be a single gas selected from nitrogen, helium, neon, argon, krypton, xenon, radon, hydrogen or the like or a mixture of these gases. Further, impurities such as oxygen, organic silicides, ammonium bases, or the like are sufficiently removed from the inert gas so that the inert gas is chemically clean and the inert gas is dried so that the moisture is 5% or lower. Impurities such as organic silicides, ammonium bases, or the like are sufficiently removed from the dry air, so that the dry air is chemically clean, and the dry air is dried so that the moisture is 5% or lower. The inert gas and dry air pass through the filter 30 and temperature-controlled dryer 31 and are again subjected to the impurity removal process and drying process.

The inert gas supply system 33 includes a normally closed type first control valve 36 which is opened by a driving force provided from an external apparatus. The dry air supply system 35 includes a normally opened type second control valve 37 which is closed by the driving force provided from the exterior apparatus. The first and second control valves 36, 37 are connected to a light source control system 38, which serves as a control apparatus, and are opened and closed by a driving force provided from the light source control system 38. The inert gas supply system 33 and the dry air supply system 35 are joined to each other at a downstream of the first and second control valves 36, 37 and connected to the air supply pipe 29.

The light source chamber 16 is connected by an air exhaust pipe 39 to an exhaust duct 40, which serves as an exhaust apparatus of the micro device plant. Further, an outlet 15a of the chamber 15 is also connected to the exhaust duct 40. This discharges the inert gas and dry air supplied into the light source chamber 16 from the plant via the exhaust duct 40. Further, an exhaust volume monitor 41, which serves as an exhaust monitoring means or an operation condition detecting mechanism, is located near the outlet 15a of the chamber 15 to detect the exhaust volume of the exhaust duct 40. The detection signal of the exhaust volume monitor 41 is provided to the light source control system 38.

Further, an oxygen sensor 42, which serves as an environment monitoring means or an operation condition detecting mechanism, is arranged in the chamber 15 to detect the oxygen concentration in the chamber 15. The detection signal of the oxygen sensor 42 is provided to the light source control system 38.

The exposure apparatus main body 11 will be described next. A first lens barrel 46, which serves as a second airtight chamber, a reticle stage 47, a second lens barrel 48, which serves as a third airtight chamber, and a wafer stage 49 are arranged in a chamber 45 of the exposure apparatus main body 11. The reticle stage 47 holds a reticle R, serving as a mask on which a predetermined pattern is formed, so that the reticle R is perpendicular to the optical axis of the laser light. Further, the wafer stage 49 holds a wafer W, which serves as a substrate and is coated with a photoresist that is photosensitive to laser light, so that the wafer W is movable in a plane perpendicular to the optical axis of the laser light and is finely movable along the optical axis.

An illumination optical system 50 for illuminating the reticle R is accommodated in the first lens barrel 46. The illumination optical system 50 includes a plurality of mirrors 51, an optical integrator 52 (for example, a flyeye lens or a rod integrator), a relay optical system 53, and a condenser lens 54. A reticle blind 55 (field stop) for shaping the laser light beam is arranged downstream the relay optical system 53. Further, an aperture portion 56a is formed at one end of the first lens barrel 46, an aperture portion 56b is formed at the other end of the barrel 46, and a disc-shaped front partition plate 57, which serves as an optical element, and a disc-shaped rear partition plate 58, which serves as an optical element, are fitted into the aperture portion 56a and the aperture portion 56b, respectively. A connecting barrel 59, which serves as a fourth airtight chamber, is fitted between the front partition plate 57 and the partition plate 20 of the light source chamber 16 in the laser apparatus 12. The laser light that enters the first lens barrel 46 from the laser apparatus 12 via the connecting barrel 59 is deflected by the mirrors 51 to correspond to the shape of the first lens barrel 46 and transformed at a downstream plane of the flyeye lens 52 into a number of secondary light sources to illuminate the reticle R with a uniform illumination distribution.

A beam matching unit (BMU) 67 that forms at least part of a transmission system is arranged in the connecting barrel 59 to guide the laser light emitted from the laser apparatus 12 to the illumination optical system 50. The BMU 67 adjusts the positional relationship between the laser light emitted from the laser apparatus 12 and the optical axis of the illumination optical system 50. That is, the BMU 67 includes a plurality of optical elements and shifts the laser light by, for example, driving at least one optical element (e.g., a mirror). In the first embodiment, the connecting barrel 59 also functions as one of the airtight chambers and corresponds to the fourth airtight chamber.

Further, although the laser apparatus 12 is located on the same floor as the exposure apparatus main body 11, the laser apparatus 12 may be located, for example, on a lower utility floor. In this case, the connecting barrel 59, which has a transmission system, may also be arranged between the laser apparatus 12 and the exposure apparatus main body 11 (illumination optical system 50) to keep the entire optical axis in an inert gas ambience.

A projection optical system 60 for projecting the image of the reticle R illuminated by the illumination optical system 50 onto the wafer W is accommodated in the second lens barrel 48. The projection optical system 60 includes lenses 61, which serve as a plurality of optical elements. A disc-shaped partition plate 63 is fitted into the aperture portion 62 of each end of the second lens barrel 48.

An aberration compensation plate (for example, a plane parallel plate, made from quartz, fluorite, or the like, on which surface fine bumps are formed), not shown, for compensating aberration (for example, distortion, spherical aberration, coma aberration, or the like), especially, the asymmetrical-about-the-optical-axis component of the aberration is arranged at each end of the second lens barrel 48. The aberration compensation plate may alternatively be used as the partition plate 63. Further, when a replaceable contamination-prevention plate (a plane parallel plate, or the like) is provided on the wafer side of the projection optical system 60, the contamination-prevention plate may be alternatively used as the partition plate. The contamination-prevention plate prevents scattered particles, which are produced from the resist by the laser light illumination, from adhering to the optical element nearest the wafer W of the projection optical system 60.

A wafer loader 64 for exchanging the wafer W mounted on the wafer stage 49 is located near the wafer stage 49. A wafer exchange door 65 that can be opened and closed is arranged near the wafer loader 64 on the wall of the chamber 45. The wafer W mounted on the wafer stage 49 is exchanged by opening and closing the wafer exchange door 65. When, for example, the exposure apparatus main body 11 and a coater-developer are connected in an in-line configuration, the wafer W is conveyed between the two apparatuses through the wafer exchange door 65 by a wafer loader 64, and a cassette in which a plurality of wafers are contained is arranged at a predetermined location in the chamber 45. In this case, the wafer W is conveyed between the wafer stage 49 and the cassette by the wafer loader 64, and the cassette is exchanged by an operator or by an automated guided vehicle having a cassette loading mechanism.

Further, a reticle exchange door 66 that can be opened and closed is arranged near the reticle stage 47 on the wall of the chamber 45. The reticle R mounted on the reticle stage 47 is exchanged by opening and closing the reticle exchange door 66. Although not specifically illustrated, a reticle loader is arranged between the reticle stage 47 and a cassette (to be exact, a reticle library in which a plurality of cassettes are loaded) containing the reticle R, and the reticle loader loads, unloads, or exchanges the cassette via the exchange door 65.

In the first embodiment, the wafer loader 64 and the reticle loader are arranged in the chamber 45. However, the wafer loader 64 and the reticle loader may be arranged in a housing separated from the chamber 45. In this case, the inert gas (purge gas) in the chamber 45 may flow into the housing since the pressure inside the chamber 45 is set higher than that inside the housing. For this reason, it is preferable that an exhaust duct be provided for the housing, and, further, a sensor detecting the concentration of the inert gas or oxygen in the housing may be provided. It is also preferable that the exchange doors 65,66 be located at the portion where the chamber 45 and the loader housing are connected.

A purge gas supply system 69 similar to the purge gas supply system 28 is connected to the connecting barrel 59, the first lens barrel 46, and the second lens barrel 48. That is, the purge gas supply system 69 is also equipped with the inert gas supply system 33, which supplies the inert gas from the first tank 32, and the dry air supply system 35, which supplies dry air from the second tank 34. The inert gas supply system 33 is equipped with the first control valve 36, and the dry air supply system 35 is equipped with the second control valve 37. The first and second control valves 36, 37 are connected to an exposure apparatus control system 73,which serves as a control apparatus or a light source control apparatus.

Downstream to the filter 30 and the temperature-controlled dryer 31, the purge gas supply system 69 is connected to the connecting barrel 59 by way of an air supply pipe 70, the first lens barrel 46 by way of an air supply pipe 71, and the second lens barrel 48 by way of an air supply pipe 72.

The connecting barrel 59 is connected to the exhaust duct 40, which is provided at an outlet 45a of the chamber 45, through an exhaust pipe 74. The first lens barrel 46 is connected to the exhaust duct 40 through an exhaust pipe 75, and the second lens barrel 48 is connected to the exhaust duct 40 through an exhaust pipe 76. This discharges the inert gas and dry air supplied into the connecting barrel 59, the first lens barrel 46, and the second lens barrel 48 from the plant through the exhaust duct 40. Some of the inert gas and dry air that leaks into the chamber 45 is also discharged from the plant through the exhaust duct 40. An exhaust volume monitor 77, which serves as an exhaust monitoring means for detecting the exhaust efficiency of the exhaust duct 40, is provided near the outlet 45a of the chamber 45. The detection signal of the exhaust volume monitor 77 is supplied to the exposure apparatus control system 73.

Further, interior oxygen sensors 78, which serve as an operation condition detecting mechanism, an environment monitoring means, and an environment sensor are provided in the chamber 45. The environment sensors 78 are each located in the vicinity of the wafer exchange door 65, the reticle exchange door 66, or the maintenance area of the illumination optical system 50 to detect the oxygen concentration. The detection signals of the environment sensors 78 are provided to the exposure apparatus control system 73. The exposure apparatus control system 73 is also connected to an exterior oxygen sensor 79, which serves as an environment monitoring means or an operation condition detecting mechanism for detecting the environment of the exposure apparatus main body 11 (i.e., the oxygen concentration in the clean room).

Next, the switching operation of the purge gas supply systems 28, 29 and the operation of the exposure apparatus main body 11 will be described.

When the laser apparatus 12 and the exposure apparatus main body 11 are deactivated, electric power is not supplied to the light source control system 38 and the exposure apparatus control system 73, and driving force is not supplied to the first and second control valves 36, 37. Accordingly, the first control valve 36 is closed, and the second control valve 37 is open. In this state, the light source chamber 16, the connecting barrel 59, the first lens barrel 46, and the second lens barrel 48 are connected to the dry air supply system 35 via the air supply pipes 29, and 70-72. Thus, dry air is supplied to the light source chamber 16, the connecting barrel 59, the first lens barrel 46, and the second lens barrel 48.

When the power supply to the laser apparatus 12 and the exposure apparatus main body 11 are activated, electric power is supplied to the light source control system 38 and the exposure apparatus control system 73, and a predetermined driving force (for example, electric power, pneumatic pressure, hydraulic pressure, or the like) is supplied to the first control valve 36. This opens the control valve 36. Further, the predetermined driving force is supplied to the second control valve 37. This closes the control valve 37. Accordingly, the light source chamber 16, the connecting barrel 59, the first lens barrel 46, and the second lens barrel 48 are connected to the inert gas supply system 33 via the air supply pipes 29, and 70-72. Thus, inert gas is supplied to the light source chamber 16, the connecting barrel 59, the first lens barrel 46, and the second lens barrel 48.

In this state, laser light, which is emitted from the laser apparatus 12, illuminates the reticle R by way of the illumination optical system 50, and the image of the pattern on the reticle R is transferred to a predetermined shot area on the wafer W by way of the projection optical system 60. Subsequently, the wafer W moves so that the next shot area is brought to the exposure field, and the exposure operation is repeated in a stepwise manner until all of the shot areas on the wafer W are exposed.

When a predetermined number of wafers W is exposed in this manner, the wafer exchange door 65 is opened, and the wafer loader 64 exchanges the predetermined number of wafers W with new wafers W. In this state, the interior oxygen sensors 78 near the wafer exchange door 65 detect the oxygen concentration of the ambient gas. When the detected oxygen concentration is greater than or equal to the oxygen concentration of the atmosphere (for example, 18%), the inert gas supply to the light source chamber 16, the connecting barrel 59, the first lens barrel 46, and the second lens barrel 48 is continued, and the transference of the pattern on the reticle R to the new wafers W is performed.

On the other hand, when the detected oxygen concentration is less than the oxygen concentration of the atmosphere, the inert gas supply to the light source chamber 16, the connecting barrel 59, the first lens barrel 46, and the second lens barrel 48 is immediately stopped, and the inert gas supply is switched to the dry air supply. That is, the supply of the driving forces to the first control valve 36 and the second control valve 37 from the light source control system 38 and the exposure apparatus control system 73 is stopped. This closes the first control valve 36, opens the second control valve 37, and supplies chemically clean dry air to the light source chamber 16, the connecting barrel 59, the first lens barrel 46, and the second lens barrel 48. Further, the power supply to the electrodes 25 in the laser excitation portion 17 is stopped, and the laser light oscillation is stopped.

Further, when the reticle exchange door 66 is opened to exchange the reticle R, the interior oxygen sensor 78 near the reticle exchange door 66 detects the oxygen concentration of the ambient gas. Based on the detected oxygen concentration, the purge gas is selectively switched, and the laser light oscillation is selectively stopped.

The switching operation to the dry air from the inert gas and the stopping of the laser light oscillation are performed based on one of the detection results of the oxygen sensor 42, the interior oxygen sensor 78, and the exterior oxygen sensor 79 when the oxygen concentration is, for example, less than 18%. The switching operation is also performed when the chambers 15, 45 are partially opened for maintenance, such as when replacing the optical elements of the exposure apparatus main body 11 and the laser apparatus 12 (for example, a laser output window ). Further, the switching operation is also performed to preclude the backflow of the inert gas into the chambers 15, 45 based on the results of the exhaust volume monitors 41, 77 even when the exhaust volume of the exhaust duct 40 falls below a predetermined value.

Accordingly, the first embodiment has the advantages described below.
(1) A plurality of the internal oxygen sensors 78 for detecting the oxygen concentration are arranged at various locations in the chamber 45 of the exposure apparatus main body 11. Also, the oxygen sensor 42 is provided to detect the oxygen concentration in the chamber 15 of the laser apparatus 12. Further, the external oxygen sensors 79 detect the oxygen concentration in the clean room in which the exposure apparatus main body 11 and the laser apparatus 12 are installed. When the oxygen concentration in the ambient gas detected by the oxygen sensors 42, 78, 79 is greater than or equal to the oxygen concentration of the atmosphere, the light source chamber 16, the connecting barrel 59, the first lens barrel 46, and the second lens barrel 48 are supplied and purged with the inert gas.
   Thus, contaminants such as organic silicides, ammonium bases, or the like are prevented from entering the light source chamber 16, the connecting barrel 59, the first lens barrel 46, and the second lens barrel 48. Therefore, clouding caused by the deposition of the contaminants on the surface of each optical element in the light source chamber 16, the connecting barrel 59, the first lens barrel 46, and the second lens barrel 48 is suppressed. As a result, the temporal decrease in the laser light intensity at the reticle R and the wafer W, changes in the optical characteristics of the illumination optical system 50 and the projection optical system 60 (for example, transmittance, aberration, magnification, or the like), and changes in the variation of the illumination distribution within the laser light illumination areas on the reticle R and the wafer W are avoided or drastically reduced. Thus, the pattern on the reticle R is always accurately transferred to the wafer W, and the throughput of the exposure apparatus is maintained at a high level. Furthermore, the absorption of the laser light by oxygen is also reduced. This prevents high attenuation of the laser light intensity at the reticle R and the wafer W. Therefore, accurate and efficient transference of the pattern on the reticle R to the wafer W is enabled.
(2) When the oxygen concentration in the ambient gas detected by the oxygen sensors 42, 78, 79 is less than the oxygen concentration of the atmosphere, the purge gas supplied to the light source chamber 16, the connecting barrel 59, the first lens barrel 46, and the second lens barrel 48 is switched to the dry air from the inert gas. Therefore, even when the hermeticity of, for example, the light source chamber 16, the connecting barrel 59, the first lens barrel 46, and the second lens barrel 48 decreases, the inert gas does not leak into the chambers 15, 45 and further into the clean room. Thus, a satisfactory working environment in the clean room is maintained. In this state, the dry air is supplied to the light source chamber 16, the connecting barrel 59, the first lens barrel 46, and the second lens barrel 48. This prevents the entrance of the contaminants and suppresses clouding of each optical element. This is particularly effective when helium, which is lighter than nitrogen, is used as the purge gas.
(3) The exhaust volume monitors 41, 77, which detect the exhaust volume of the inert gas discharged from the plant, are provided in the duct 40. When the exhaust volume detected by the exhaust volume monitors 41 and 77 is less than a predetermined value, the purge gas supplied to the light source chamber 16, the connecting barrel 59, the first lens barrel 46, and the second lens barrel 48 is switched to the dry air from the inert gas. Therefore, even if the exhaust efficiency is decreased for some reason, the inert gas does not flow backward into the chambers 15, 45 and further into the clean room. Thus, the clean room is maintained in a satisfactory working environment.
(4) When the power supply to the exposure apparatus control system 73 and the light source control system 38 is stopped because of, for example, power outage or a long shutdown, the dry air is automatically supplied to the light source chamber 16, the connecting barrel 59, the first lens barrel 46, and the second lens barrel 48. Therefore, especially in the case of along shutdown, contaminants do not adhere to or deposit on any surface of the optical elements of the light source chamber 16, the connecting barrel 59, the first lens barrel 46, and the second lens barrel 48. Thus, the clouding of each optical element is suppressed for a long period, and the clean room is maintained in a satisfactory working environment.
(5) Internal oxygen sensors 78 are located near the reticle exchange door 65, the wafer exchange door 66, and also near the maintenance area of the illumination optical system 50. Therefore, in the chamber 45, the oxygen concentration of the ambient gas near the areas where the operator frequently approaches is always maintained at a level of greater than or equal to a predetermined value.
(6) The employed inert gas and dry air are chemically cleaned and dried to a sufficient level. Therefore, the clouding of each optical element is suppressed.
(7) The purge gas supply systems 28, 69 are equipped with the filter 30 and the temperature-controlled dryer 31. Therefore, the purge gas supplied to the light source chamber 16, the connecting barrel 59, the first lens barrel 46, and the second lens barrel 48 is further cleaned and dried. Therefore, clouding of each optical element is further suppressed.
(8) The front partition plate 57 and the rear partition plate 58 are fitted into the aperture portion 56a and the aperture portion 56b of the first lens barrel 46, respectively, and the partition plate 63 is fitted into the aperture portion 62 of each end of the second lens barrel 48. Also, the partition plate 20 is fitted into the aperture 18 of the light source chamber 16. Therefore, none of the optical elements accommodated in the light source chamber 16, the first lens barrel 46, and the second lens barrel 48 are directly exposed to the atmosphere even when the exposure apparatus main body 11 and the laser apparatus 12 are separated. Therefore, contamination of the surfaces of the optical elements is prevented.
(9) The light source chamber 16 is accommodated in the chamber 15, and the first lens barrel 46 and the second lens barrel 48 are accommodated in the chamber 45. Therefore, the inert gas in the light source chamber 16, the first lens barrel 46, and the second lens barrel 48 does not directly leak into the clean room. Further, the atmosphere in the clean room does not directly contact the light source chamber 16, the first lens barrel 46, and the second lens barrel 48. Thus, the deposition of contaminants on the optical elements is suppressed.

### (Second Embodiment)

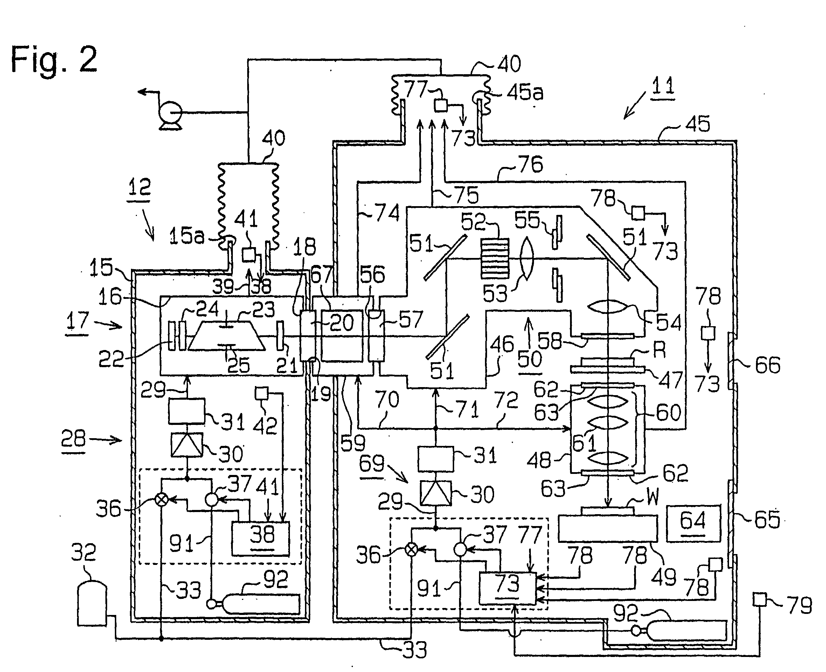

Next, referring to FIG. 2, an exposure apparatus main body 11 and a laser apparatus 12 according to a second embodiment of the present invention will be described mainly focusing on portions differing from the first embodiment. In the second embodiment, as shown in FIG. 2, the configuration of a dry air supply system 91 differs from that of the first embodiment. That is, the dry air supply system 91 is equipped with a dry air tank 92, which serves as a holding means that stores and holds dry air. The dry air tanks 92 are detachably installed in the chambers 15, 45. When the supply of dry air to the light source chamber 16, the connecting barrel 59, the first lens barrel 46, and the second lens barrel 48 is necessary, dry air is supplied from the dry air tank 92 through air supply pipes 29, and 70-72.

Thus, the second embodiment has the advantages described below in addition to advantages (1)-(9) of the first embodiment.
(10) The dry air tanks 92 are provided in the exposure apparatus main body 11 and the laser apparatus 12. Therefore, the light source chamber 16, the connecting barrel 59, the first lens barrel 46, and the second lens barrel 48 are purged with dry air even when the exposure apparatus main body 11 and the laser apparatus 12 are separated from the utility plant of the micro device plant. Thus, the interior of the light source chamber 16, the connecting barrel 59, the first lens barrel 46, and the second lens barrel 48 remain clean even when the exposure apparatus main body 11 and the laser apparatus 12 are transferred and assembled and clouding of each optical element is suppressed.
(11) Each of the chambers 15 and 45 is independently provided with the dry air tank 92. Therefore, even when the exposure apparatus main body 11 and the laser apparatus 12 are separated, the light source chamber 16, the first lens barrel 46, and the second lens barrel 48 are purged with dry air. This facilitates transportation of the exposure apparatus main body 11 and the laser apparatus 12.

### (Third Embodiment)

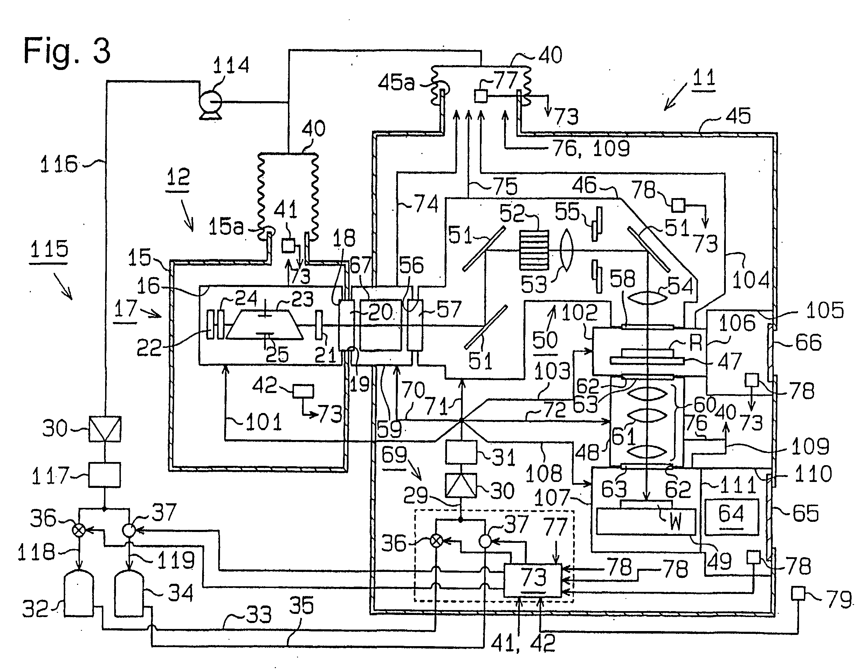

Next, referring to FIG. 3, an exposure apparatus main body 11 and a laser apparatus 12 according to a third embodiment of the present invention will be described mainly focusing on the portions differing from the first embodiment. In the third embodiment, as shown in FIG. 3, the purge gas supply system 69 equipped in the exposure apparatus main body 11 is connected not only to the connecting barrel 59, the first lens barrel 46, and the second lens barrel 48 but also to the light source chamber 16 in the laser apparatus 12 through an air supply pipe 101. Accordingly, no purge gas supply system is provided in the laser apparatus 12. In this case, the detection signals of the oxygen sensor 42 and the exhaust volume monitor 41 are provided to the exposure apparatus control system 73.

Further, a reticle stage chamber 102 enclosing the reticle stage 47 is arranged in the chamber 45. The reticle stage chamber 102 is connected to the purge gas supply system 69 through an air supply pipe 103 branching from the air supply pipe 29 and to the exhaust duct 40 through an exhaust pipe 104. A front chamber 105 is defined between the reticle stage chamber 102 and the reticle exchange door 66, and the reticle stage chamber 102 and the front chamber 105 are separated by an open/close door 106. The internal oxygen sensors 78 is located in the front chamber 105. A reticle library, not shown, is arranged in the front chamber 105. The reticle loader may be arranged in the front chamber 105.

A wafer stage chamber 107 enclosing the wafer stage 49 is arranged in the chamber 45. The wafer stage chamber 107 is connected to the purge gas supply system 69 through an air supply pipe 108 branching from the air supply pipe 29 and is to the exhaust duct 40 through an exhaust pipe 109. A front chamber 110 is defined between the wafer stage chamber 107 and the wafer exchange door 65, and the wafer stage chamber 107 and the front chamber 110 are separated by an open/close door 111. The internal oxygen sensors 78 are located in the front chamber 110. Further, the wafer loader 64 is normally located in the front chamber 110 and moved into the wafer stage chamber 107 or out of the chamber 45 when necessary, such as when exchanging wafers.

Further, a purge gas recovering system 115, which serves as a recovering apparatus, is connected to the exhaust port of a blower 114 for forcibly discharging the gas in the exhaust duct 40. A filter 30, which removes impurities from the recovered purge gas, and a dryer 117, which serves as a cleaning apparatus and dries the recovered purge gas, are arranged from the upstream side in the recovering pipe 116 of the purge gas recovering system 115.

The recovering pipe 116 bifurcates downstream to the dryer 117. A first recovering pipe 118 is connected to the first tank 32 through the first control valve 36. The first control valve 36 is opened by the driving force provided from the exposure apparatus control system 73, and the inert gas is recovered in the first tank 32 through the first recovering pipe 118. A second recovering pipe 119 is connected to the second tank 34 through the second control valve 37. The second control valve 37 is closed by the driving force provided from the exposure apparatus control system 73, and dry air is recovered in the second tank 34 through the second recovering pipe 119.

Although, in the third embodiment, the inert gas and dry air are separately recovered, only the inert gas may be recovered. Further, when helium is used as the inert gas (purge gas), a refrigerating machine may be arranged upstream to the dryer 117 (but downstream to the filter 30). The refrigerating machine, for example, cools the recovered mixed gas to the liquid nitrogen temperature by means of adiabatic compression cooling, liquefies the air constituents, and separates the liquefied air from the purge gas (helium gas). Subsequently, the helium gas kept in a gaseous state in the refrigerating machine is recovered in the first tank 32 though the first recovering pipe 118 and reused (recycled). The liquefied air is vaporized in a recovering bomb, not shown, and recovered in the second tank 34 through the second recovering pipe 119.

In the third embodiment the inert gas and dry air are recovered in the first tank 32 and second tank 34, respectively. However, in addition to the first tank 32, the first recovering pipe 118 may be connected to a recovering tank that differs from the first tank 32 to temporarily store the helium gas in the recovering tank and the first tank 32. Further, a supply pipe 33 may be connected to the recovering tank and the first tank 32. After mixing the helium gas from the two tanks at a predetermined ratio, the mixed helium gas is supplied to the exposure apparatus main body 11 and the laser apparatus 12. In this case, by independently adjusting the supply volume from each tank with, for example, an open/close valve, the helium concentration may always be maintained at a constant level or greater. Such adjustment of supply volume may be performed with the recovered dry air.

Thus, the third embodiment has the advantages described below in addition to advantages (1)-(9) of the first embodiment.
(12) The exposure apparatus main body 11 and the laser apparatus 12 share the purge gas supply system 69. Thus, the purge gas supply system 28 of the laser apparatus 12 is eliminated, and the number of parts is reduced drastically.
(13) The reticle stage 47 is accommodated in the reticle stage chamber 102, and the wafer stage 49 is accommodated in the wafer stage chamber 107. Therefore, the interior of the reticle stage chamber 102 and the wafer stage chamber 107 may be purged with, for example, inert gas. This suppresses the attenuation of the laser light in the stage chambers 102, 107. Thus, the pattern on the reticle R is accurately and efficiently transferred to the wafer W.
(14) The purge gas recovering system 115 for recovering the purge gas exhausted from the exhaust duct 40, separating the gas into the inert gas and dry air, is provided. Thus, through the reuse of the purge gas, the running costs of the exposure apparatus main body 11 and the laser apparatus 12 can be reduced.

### (Fourth Embodiment)

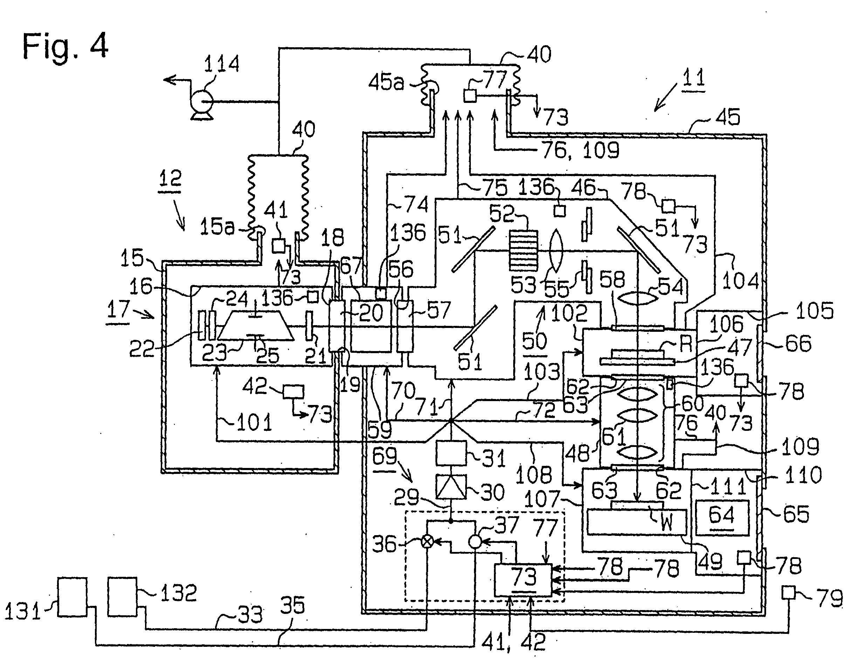

Next, referring to FIG. 4, an exposure apparatus main body 11 and a laser apparatus 12 according to a fourth embodiment of the present invention will be described mainly focusing on the portions differing from the third embodiment.

In the fourth embodiment, as shown in FIG. 4, an ambient air intake apparatus 131, which serves as a supply source of dry air, is connected to the dry air supply system 35. The ambient air intake apparatus 131 draws in air from the clean room and has a chemical filter and a HEPA filter, which remove impurities (organic substances, ammonium bases, or the like) from the air, and a dryer, which reduces the humidity of the air chemically cleaned by the filters to a level of about 5% or less. In this manner, the ambient air intake apparatus 131 generates chemically clean dry air and supplies the dry air to the dry air supply system 35.

Further, a nitrogen generating apparatus 132, which serves as a supply source of an inert gas (in this case, nitrogen), is connected to the inert gas supply system 33. The nitrogen generating apparatus 132 draws in air from the clean room and has a chemical filter and a HEPA filter, which remove impurities (organic substances, ammonium bases, or the like) from the air and an extractor, which extracts nitrogen from the air chemically cleaned by the filters. In this manner, the nitrogen generating apparatus 132 generates chemically clean and high-purity nitrogen and supplies the nitrogen to the inert gas supply system 33. Additionally, a dryer may be provided in the nitrogen generating apparatus 132 to adjust the humidity of the nitrogen.

The fourth embodiment may also be applied to the first and second embodiments. In this case, the ambient air intake apparatus 131 is connected to the dry air supply systems 35, 91 shown in FIGS. 1 and 2, and dry air is supplied from the ambient air intake apparatus 131. Further, the nitrogen generating apparatus 132 is connected to the inert gas supply system 33, and nitrogen is supplied from the nitrogen generating apparatus 132. In the second embodiment, a selector valve may be provided for the dry air supply system 91 to selectively supply dry air to the air supply pipe 29 from the dry air tank 92 and the ambient air intake apparatus 131.

### (Modified Examples)

The present invention may be modified as described below.
(1) As shown in FIG. 4, internal air-tight-chamber oxygen sensors 136 may be positioned in the light source chamber 16, the connecting barrel 59, the first lens barrel 46, and the second lens barrel 48. The oxygen sensors 136 may also be applied to the first, second, and third embodiments. The oxygen sensors 136 detect the concentrations of the residual oxygen in the light source chamber 16, the connecting barrel 59, the first lens barrel 46, and the second lens barrel 48 when the purge gas is switched to dry air (second gas) from the inert gas (first gas). The oxygen sensors 136 provide signals indicating the concentrations of the residual oxygen to the exposure apparatus control system 73, which serves as a light emission control apparatus. The exposure apparatus control system 73 controls the laser apparatus 12 so that the emission of illumination light is prohibited until the concentrations of residual oxygen in the light source chamber 16, the connecting barrel 59, the first lens barrel 46, and the second lens barrel 48 becomes lower than or equal to a predetermined value (e.g., 1%).
   Such control prevents the emission of the illumination light from the laser apparatus 12 until the light source chamber 16, the connecting barrel 59, the first lens barrel 46, and the second lens barrel 48 are sufficiently purged with the inert gas. Since the illumination light is emitted only when the residual oxygen concentration is lower than or equal to the predetermined value, the attenuation of the illumination light energy and the generation of ozone are suppressed. Thus, a stable amount of exposure energy is obtained from the illumination light. Further, in the first and second embodiments, a signal indicating the residual oxygen concentration may be provided to the light source control system 38 to perform a similar control.
(2) The laser apparatus 12 may be controlled so that the emission of illumination light is prohibited until a predetermined time, which is pre-measured, elapses after the purging of the inert gas is started. The predetermined time is the time period required for the residual oxygen concentration to become lower than or equal to the predetermined value.
(3) The operation for discharging gases to the exhaust duct 40 from the light source chamber 16, the first lens barrel 46, the second lens barrel 48, the connecting barrel 59, and the chambers 15, 45 may be selectively performed. For example, when the residual oxygen concentration detected by the oxygen sensor 136 is less than or equal to the predetermined value, the discharge of inert gas from the exhaust duct 40 is stopped, and when the purge gas is manually switched to dry air from the inert gas by an operator to perform maintenance, the discharge operation is performed. When purging is performed by dry air, the inert gas is discharged from the plant with no residual in the light source chamber 16, the first lens barrel 46, and the second lens barrel 48, the connecting barrel 59, and the chambers 15. This maintains a satisfactory working environment such as when performing maintenance.
(4) A gas having an oxygen concentration approximately equal to or greater than that in the atmosphere, for example, pure oxygen or mixed gas containing oxygen and inert gas, may be used as dry air.
(5) Instead of detecting the exhaust volume of the exhaust duct 40 with the exhaust volume monitors 41, 77, the flow velocity of gas in the duct 40 may be detected by a flow velocity meter.
(6) In the first and second embodiments, the partition plates 20 and 57 may be removed after the exposure apparatus main body 11 and the laser apparatus 12 are connected.
(7) In the third and fourth embodiments, the partition plates 20, 57, 58, 63 may be removed after the exposure apparatus main body 11 and the laser apparatus 12 are connected.
(8) In the first and second embodiments, a switching control for supplying the purge gas supply system 69 of the exposure apparatus main body 11 and the purge gas supply system 28 of the laser apparatus 12 with different inert gas and dry air may be performed.
(9) At least one of the light source chamber 16, the first lens barrel 46, the second lens barrel 48, and the connecting barrel 59 may be divided into a plurality of airtight chambers. Especially, the first lens barrel 46 may be divided into a plurality of airtight chambers by the reticle blind 55. In this case, each airtight chamber is treated as a unit, and the workability during installation and maintenance is improved.
(10) At least one of the light source chamber 16, the first lens barrel 46, the second lens barrel 48, and the connecting barrel 59 may include a plurality of airtight chambers. Such multiple airtight chamber configuration prevents the inert gas in the light source chamber 16, the first lens barrel 46, the second lens barrel 48, and the connecting barrel 59 from leaking directly into the chambers 15, 45. Further, the atmosphere in the clean room is prevented from directly contacting the light source chamber 16, the first lens barrel 46, the second lens barrel 48, and the connecting barrel 59. Thus, a satisfactory working environment is maintained, and the deposition of the contaminants on the optical elements is suppressed.
(11) In each embodiment, the BMU 67 can be omitted.
(12) A KrF excimer laser light source, an F₂ excimer laser light source, or a light source emitting a harmonic of a YAG laser or a metal vapor laser may be used in lieu of the ArF excimer laser light source.
(13) The present invention is embodied in a one-shot exposure type exposure apparatus, which transfers the image of the pattern on the reticle R to the wafer W with a step-and-repeat method. Alternatively, the present invention may be embodied in a scanning type exposure apparatus in which the reticle R and the wafer W are moved in synchronization, and the pattern image is transferred to the wafer W by a step-and-scan method. Further, the present invention may be applied to a mirror projection type exposure apparatus or to a proximity type exposure apparatus. The projection optical system may be a dioptric, catoptric, or cata-dioptric system, and may further be a reduction, unit-magnification, or enlarging magnification system. Further, even when the exposure apparatus does not use a projection optical system, the present invention may be applied to a laser light source and illumination optical system.
(14) Although the dioptric type projection optical system 60 is accommodated in the second lens barrel 48, the second lens barrel 48 may include a plurality of lens barrels, and a cata-dioptric projection optical system may be accommodated in the barrels.
   Cata-dioptric projection optical systems having a beam splitter and a concave mirror, which serve as reflective optical elements, such as those described in Japanese Unexamined Patent Publication No. 8-171054 (and corresponding U.S. Patent No. 5,668,672), and Japanese Unexamined Patent Publication No. 10-20195 (and corresponding U.S. Patent No. 5,835,275) or cata-dioptric projection optical systems having a concave mirror or the like, which serves as the reflective optical elements and does not employ a beam splitter, such as those described in Japanese Unexamined Patent Publication No. 8-334695 (and corresponding U.S. Patent No. 5,689,377) and Japanese Unexamined Patent Publication No. 10-3039 (and corresponding U.S. Patent Application No. 837,605 (filed on June 12, 1997) may be used as the cata-dioptric projection optical system.
   Also, a cata-dioptric system such as that described in Japanese Unexamined Patent Publication No. 10-104513 (and U.S. Patent No. 5,488,229) may be employed. The cata-dioptric system includes a plurality of refractive optical elements and two mirrors (a main mirror, which is a concave mirror, and a sub-mirror, which is a rear-surface mirror having a reflecting surface formed on the opposite side of an incident surface of a refractive element or a parallel plane plate) that are coaxially arranged. The main mirror and the sub-mirror re-image an intermediate image of a reticle pattern, which is formed by the plurality of refractive optical elements, on a wafer. In the cata-dioptric system, the main mirror and the sub-mirror are arranged continuously from the plurality of refractive optical elements. Illumination light passes through part of the main mirror to be reflected sequentially by the sub-mirror and the main mirror. Then, the illumination light passes through part of the sub-mirror and reaches the wafer.
   Further, for example, a reduction system, which has a circular image field, is telecentric on an object surface side and an image surface side, and has a projection magnification of 1/4 or 1/5, may be used as the cata-dioptric type projection optical system. Further, in the case of a scanning type exposure apparatus equipped with this cata-dioptric projection optical system, the illumination area of the illumination light may be a slit-like rectangular area having a center, which is substantially the optical axis of the projection optical system in the view field of the projection optical system, and extends along a direction generally perpendicular to the scanning direction of a reticle or wafer. By using a scanning type exposure apparatus equipped with such cata-dioptric projection optical system, a fine pattern image of about 100 nm L/S can be accurately transferred on a wafer even when, for example, an F₂ excimer laser light having a wavelength of 157nm is used as the exposure illumination light.
(15) Although the present invention is embodied in the exposure apparatus main body 11, which manufactures semiconductor devices, the present invention may also be embodied in an exposure apparatus that manufactures, for example, a liquid crystal display device, an image pick-up device, and a thin film magnetic head.
(16) The present invention may also be applied to an exposure apparatus that transfers a circuit pattern on a glass substrate, a silicon wafer, or the like to manufacture a reticle or a mask. In an exposure apparatus using DUV (deep-ultraviolet) light or VUV (vacuum-ultraviolet) light, a transmission-type reticle is generally used. Quartz glass, F-doped quartz glass, fluorite, magnesium fluoride, or quartz may be used as the reticle substrate. A reflection-type mask is used in an EUV exposure apparatus. In a proximity-type X-ray exposure apparatus or an electron beam exposure apparatus, a transmission-type mask (stencil mask, membrane mask) is used, and a silicon wafer may be used as the mask substrate.
(17) Instead of the ArF excimer laser or the F₂ excimer laser, a harmonic wave, which is generated by amplifying single-wavelength laser light of the infrared or visible band emitted from, for example, a DFB semiconductor laser or a fiber laser, with a fiber amplifier doped with erbium (or both of erbium and ytterbium) and converting the amplified light into ultraviolet light with a nonlinear optical, crystal may be used. Specifically, when the oscillated single-wavelength laser wavelength is in the range of 1.51-1.59µm, an 8-th harmonic wave in the range of 189-199nm or a 10-th harmonic wave in the range of 151-159nm may be obtained. In particular, when the oscillated wavelength is set in the range of 1.544-1.553µm, an 8-th harmonic wave in the range of 193-194nm, i.e., ultraviolet light of approximately the same wavelength as that of ArF excimer laser light, is obtained. When the oscillated wavelength is set in the range of 1.57-1.58µm, a 10-th harmonic wave in the range of 157-158nm, i.e., ultraviolet light of approximately the same wavelength as that of F₂ excimer laser light, is obtained. Further, when the oscillated wavelength is set in the range of 1.03-1.12µm, a 7-th harmonic wave in the range of 147-160nm is obtained. In particular, when the oscillated wavelength is set in the range of 1.099-1.106 µm, a 7-th harmonic wave in the range of 157-158 nm, i.e., ultraviolet light of approximately the same wavelength as that of F₂ excimer laser light, is obtained. An ytterbium-doped fiber laser can be used as a single-wavelength laser.
(18) Instead of setting the humidity of dry air and inert gas to about 5% or lower, the humidity of the inert gas may be set at a value exceeding 5%. That is, the humidity control of the inert gas may be flexible compared with that of the dry air. Therefore, a humidity controller for adjusting the humidity of the inert gas is not necessarily required.

In the manufacturing process of an exposure apparatus, an illumination optical system and a projection optical system, each having a plurality of optical elements, are incorporated in the exposure apparatus main body and undergo optical adjustments. A reticle stage and a wafer stage, each being formed from a number of mechanical components, are installed in the exposure apparatus main body connected with wiring and piping. Further, by connecting the purge gas supply systems 28, 69 to the light source chamber 16, the connecting barrel 59, the first lens barrel 46, and the second lens barrel 48, connecting the exhaust duct 40 to the chambers 15, 45, and performing overall adjustments (electrical adjustment, operation confirmation, or the like), the exposure apparatus of each of the above embodiments is manufactured. It is preferred that the exposure apparatus be manufactured in a clean room, the temperature and cleanliness level of which are controlled.

A semiconductor device is manufactured by a process including a step for designing the functions and performance of the device, a step for manufacturing a reticle in accordance with the design step, a step for producing a wafer from a silicon material, a step for exposing the wafer with the pattern on a reticle by using an exposure apparatus of one of the above embodiments, a step for assembling devices (including a dicing process, a bonding process, a packaging process), and a step for testing.

## Claims

1. An optical apparatus including an airtight chamber for accommodating optical elements, the optical apparatus being **characterized by**:
a first purge mechanism that supplies a first gas into said airtight chamber;
a second purge mechanism that supplies a second gas having a composition differing from the first gas into said airtight chamber;
an operation condition detecting mechanism that detects an operation condition of said optical apparatus; and
a control apparatus that selectively connects said airtight chamber to said first purge mechanism or said second purge mechanism based on a detection result of the operation condition detecting mechanism.

2. An optical apparatus as claimed in claim 1, further **characterized by** a light source which emits illumination light.

3. An optical apparatus as claimed in claim 2, **characterized in that** said light source includes an excimer laser light source which emits excimer laser light.

4. An optical apparatus as claimed in claim 1, further **characterized by** an illumination optical system having a plurality of optical elements and illuminating a mask with illumination light, wherein at least some of said plurality of optical elements of the illumination optical system are accommodated in said airtight chamber.

5. An optical apparatus as claimed in claim 4, further **characterized by** a projection optical system that projects at least part of a pattern formed on said mask onto a substrate.

6. An optical apparatus as claimed in claim 1, **characterized in that** said first gas is inert gas, and said second gas is oxygen, which has at least the same concentration as that in the atmosphere, or mixed gas, which contains oxygen.

7. An optical apparatus as claimed in claim 6, **characterized by** a cleaning apparatus arranged in a flow path of the first gas and the second gas to remove impurities from the gases.

8. An optical apparatus as claimed in claim 1, **characterized in that** said optical apparatus includes a housing which accommodates said airtight chamber, said operation condition detecting mechanism includes an environment monitoring means which detects the concentration of a predetermined gas inside or outside said housing, and
said control apparatus switches the purge mechanism connected to said airtight chamber from the first purge mechanism to the second purge mechanism based on the detection results of the environment monitoring means when the concentration of said predetermined gas falls below a predetermined value.

9. An optical apparatus as claimed in claim 1, **characterized in that** said optical apparatus includes an exhaust apparatus connected to said airtight chamber, said operation condition detecting mechanism includes an exhaust monitoring means that detects the exhaust volume of said exhaust apparatus, and said control apparatus switches the purge mechanism connected to said airtight chamber from the first purge mechanism to the second purge mechanism based on the detection results of the environment monitoring means when said exhaust volume falls below a predetermined value.

10. An optical apparatus as claimed in claim 1, **characterized in that** the purge mechanism connected to said airtight chamber is switched from the first purge mechanism to the second purge mechanism when at least one of said operation condition detecting mechanism and said control apparatus is in a deactivated state.

11. An optical apparatus as claimed in claim 1, **characterized in that** said control apparatus connects said first purge mechanism to said airtight chamber when said optical apparatus operates and connects said second purge mechanism to said airtight chamber when a condition for using said first gas is not satisfied.

12. An optical apparatus as claimed in claim 11, **characterized in that** said second purge mechanism is connected to the airtight chamber when part of the housing accommodating said airtight chamber is in an opened state, when a power supply of said optical apparatus is off, or when said optical apparatus is being transported, assembled, or adjusted.

13. An optical apparatus as claimed in any one of claims 1-12, further **characterized by** a holding means that stores and holds said second gas.

14. An exposure apparatus that transfers a pattern of a mask to a substrate, the exposure apparatus being **characterized by**:
a light source which emits illumination light;
an airtight chamber accommodating at least some of a plurality of optical elements disposed between said light source and said substrate;
a first purge mechanism that supplies a first gas into said airtight chamber;
a second purge mechanism that supplies a second gas having a composition differing from said first gas into said airtight chamber;
an operation condition detecting mechanism that detects an operation condition of said exposure apparatus; and
a control apparatus that selectively connects said airtight chamber to said first purge mechanism or said second purge mechanism based on a detection result of the operation condition detecting mechanism.

15. An exposure apparatus as claimed in claim 14, **characterized in that** said airtight chamber includes a first airtight chamber which accommodates the optical elements in said light source, a second airtight chamber which accommodates at least one of the optical elements disposed between said light source and said mask, and a third airtight chamber which accommodates at least one of the optical elements disposed between said mask and said substrate.

16. An exposure apparatus as claimed in claim 14, further **characterized by** a recovering apparatus that recovers said first gas through at least one of the housing accommodating said airtight chamber and said airtight chamber.

17. An exposure apparatus as claimed in claim 15, **characterized in that** said second gas is chemically clean dry air.

18. An exposure apparatus as claimed in claim 14, further **characterized by** a sensor that detects the concentration of either one of said first gas or oxygen in said airtight chamber, and a light emission control apparatus that controls said light source based on an output of said sensor.

19. An exposure apparatus as claimed in claim 18, **characterized in that** said sensor detects said oxygen concentration, and said light emission control apparatus prohibits the emission of said illumination light from said light source until said oxygen concentration becomes less that or equal to a predetermined value.

20. An exposure apparatus as claimed in claim 19, **characterized in that** said airtight chamber includes a plurality of airtight chambers disposed in a light path of said illumination light, a plurality of sensors are provided in each of said plurality of airtight chambers, and said light emission control apparatus controls said light source based on outputs of said plurality of sensors.

21. An exposure apparatus as claimed in claim 20, further **characterized by** an illumination optical system illuminating said mask with said illumination light, a projection optical system projecting at least part of said mask pattern, which is illuminated with said illumination light, onto said substrate, and a transmission system disposed between said light source and said illumination optical system, wherein said plurality of airtight chambers includes at least one of a first airtight chamber provided in said light source, a second airtight chamber accommodating at least some of optical elements forming said illumination optical system, a third airtight chamber accommodating at least some of optical elements forming said projection optical system, and a fourth airtight chamber accommodating at least some of optical elements forming said transmission system.

22. An exposure apparatus as claimed in claim 20, **characterized in that** said exposure apparatus includes an illumination optical system which illuminates said mask with said illumination light, and said airtight chamber includes at least two airtight chambers which accommodates the optical elements of the illumination optical system, wherein said at least two airtight chambers are each provided with a sensor.

23. An exposure apparatus as claimed in claim 14, **characterized in that** said control apparatus connects said airtight chamber to said second purge mechanism in order to supply said second gas into the airtight chamber when the emission of said illumination light from said light source is interrupted or stopped.

24. An exposure apparatus as claimed in claim 23, further **characterized by** a housing which accommodates said airtight chamber and an exhaust apparatus connected to said housing and operated when said second gas is supplied.

25. An exposure apparatus as claimed in claim 24, further **characterized by** an environment sensor that detectes the environment in said housing, wherein said exhaust apparatus is controlled based on an output of said environment sensor.

26. An exposure apparatus as claimed in claim 24 or 25, **characterized in that** said housing includes either a first chamber which accommodates said light source or a second chamber which accommodates the exposure apparatus main body.

27. A laser light source used in an exposure apparatus that transfers a pattern of a mask onto a substrate, the laser light source being **characterized by**:
a tank which stores a second gas, which has a composition differing from a first gas that is supplied during the operation of said exposure apparatus; and
piping which introduces said second gas into the laser light source when the laser light source is separated from said exposure apparatus.

28. A gas supply method for supplying a predetermined gas to an airtight chamber, which accommodates optical elements and is disposed in an optical apparatus, the gas supply method being **characterized by**:
detecting an operation condition of said optical apparatus;
selectively supplying the airtight chamber with a first gas or a second gas, the composition of which differs from the first gas, as said predetermined gas based on the detection result.

29. A gas supply method as claimed in claim 28, **characterized in that** said first gas is inert gas, and said second gas is oxygen, which has at least the same concentration as that in the atmosphere, or mixed gas, which contains oxygen.

30. A gas supply method as claimed in claim 29, wherein said optical apparatus includes a housing accommodating said airtight chamber, the gas concentration in the inside or outside of said housing is detected, and, based on the results of the detection, said first gas is supplied to said airtight chamber when said gas concentration exceeds a predetermined value, and said second gas is supplied to the airtight chamber when said gas concentration falls below said predetermined value.

31. A gas supply method as claimed in claim 29, wherein said optical apparatus includes an exhaust apparatus connected to said airtight chamber, the gas supply method being **characterized by**:
detecting an exhaust volume of said exhaust apparatus;
and
supplying said first gas to said airtight chamber when said exhaust volume is greater than or equal to a predetermined value, and supplying said second gas to said airtight chamber when the gas concentration falls below said predetermined value.

32. A gas supply method as claimed in claim 29, **characterized in that** said first gas is supplied to said airtight chamber when said optical apparatus is operated.

33. A gas supply method as claimed in claim 32, **characterized in that** said second gas is supplied to said airtight chamber when said airtight chamber or part of a housing accommodating the airtight chamber is opened or when a power supply of the optical apparatus is off.

34. A gas supply method as claimed in claim 29, **characterized in that** said optical apparatus includes an illumination optical system which illuminates a mask with illumination light from a light source, a projection optical system which projects at least part of a pattern of the mask illuminated with said illumination light onto a photosensitive substrate, and a transmission system disposed between said light source and said illumination optical system, wherein said airtight chamber is provided in at least one of said illumination optical system, said projection optical system, and said transmission system.

35. An exposure method for projecting a pattern of a mask onto a substrate using a gas supply method described in any one of claims 28-34.

36. An exposure method for projecting a pattern formed on a mask onto a substrate, the exposure method being **characterized by** supplying said first gas to said airtight chamber using the gas supply method described in claim 32 before projecting said pattern onto said substrate.

37. A device manufacturing method including a step for projecting a pattern formed on a mask onto a substrate, the device manufacturing method **characterized by** a step of:
supplying said first gas to said airtight chamber using the gas supply method described in claim 32 before projecting said pattern onto said substrate is included.
